# EUROPEAN PATENT APPLICATION

(11) **EP 4 671 781 A1**
(43) Date of publication of application: **31.12.2025**
(21) Application number: 25181595.7
(22) Date of filing: 09.06.2025
(51) Int. Cl.: G01R 31/36, G01R 31/52

(54) **METHOD AND APPARATUS FOR DIAGNOSING AN INTERNAL SHORT CIRCUIT IN A BATTERY**

(30) Priority: 24.06.2024 KR 20240082114
(71) Applicant: SAMSUNG SDI CO., LTD., Yongin-si, Gyeonggi-do 17084 (KR)
(72) Inventor: KIM, Yongchan, 17084 Yongin-si (KR); YUN, Junseo, 17084 Yongin-si (KR); LEE, Jaeyoung, 17084 Yongin-si (KR); KIM, Byung Ik, 17084 Yongin-si (KR); OH, Jeongwon, 17084 Yongin-si (KR)
(74) Representative: Marks & Clerk LLP

(57) **Abstract**

A method and apparatus for diagnosing an internal short circuit in a battery are provided. The method includes measuring charge efficiency of a battery cell in each of a plurality of charge/discharge cycles; measuring a temperature of the battery cell in each of the charge/discharge cycles; calculating a change in the charge efficiency in a charge/discharge cycle from a previous charge/discharge cycle in each of the charge/discharge cycles; calculating change in the temperature in the charge/discharge cycle from the previous charge/discharge cycle in each of the charge/discharge cycles; and diagnosing an internal short circuit of the battery cell based on the change in the charge efficiency and the change in the temperature.

## Description

### BACKGROUND

### (1) Field

This disclosure relates to a method and apparatus for diagnosing an internal short circuit in a battery.

### (2) Description of Related Art

Lithium secondary batteries in the form of small batteries have increasingly been used in devices such as mobile phones and laptops. The demand for large-capacity secondary batteries has also increased recently, with long life, high output, and safety being desired due to the characteristics of large-capacity applications.

Lithium secondary batteries may be made by manufacturing an anode and a cathode using anode materials and cathode materials that absorb and release lithium ions, installing a separator between the anode and the cathode, and providing an electrolyte. Lithium ions move between the anode and the cathode through the electrolyte, thereby allowing for charging and discharging of the battery to occur.

A secondary battery (i.e., battery cell) may include an electrode assembly including an anode, a cathode, and a separator interposed between the cathode and the anode, a case accommodating the electrode assembly, and electrode terminals electrically connected to the electrode assembly. The charging and discharging of the battery cell may be performed by providing electrolyte in the case of the battery cell and causing an electrochemical reaction between the anode, the cathode, and electrolyte. The case of the battery cell may be formed in various shapes, such as cylindrical or rectangular, depending on the purpose of the battery cell.

In battery cells, an internal short circuit in which the anode and the cathode inside the battery cell are short-circuited due to loss of separator function may occur. The internal short circuit in the battery cell may be caused, for example, by deformation due to external impact, metallic foreign matter introduced during the manufacturing process, or the formation of lithium or copper dendrites due to electrochemical reactions. The internal short circuit in the battery cell may cause safety problems such as thermal runaway.

Furthermore, in secondary batteries used in large-capacity systems such as an electric vehicle or an energy storage system (ESS), long life, high output characteristics, and safety are desired due to the characteristics of a large-capacity system. But, when scrap-type foreign matter including abnormal metal foreign matter or substrates contaminates a battery, a phenomenon in which lithium salt grows around the foreign matter area, and the lithium salt penetrates the separator under pressurized conditions in which cell swelling is restricted by the external partition may occur. This results in the risk of thermal runaway occurring due to an internal short circuit in the battery cell.

### SUMMARY

At least one embodiment provides a method and apparatus for diagnosing an internal short circuit in battery, which may preemptively diagnose the internal short circuit of a lithium secondary battery.

According to an embodiment, a method of diagnosing an internal short circuit in a battery may be provided. The method of diagnosing an internal short circuit in a battery includes: measuring charge efficiency of a battery cell in each of a plurality of charge/discharge cycles; measuring a temperature of the battery cell in each of the plurality of the charge/discharge cycles; calculating a change in the charge efficiency in a charge/discharge cycle from a previous charge/discharge cycle in each of the plurality of charge/discharge cycles; calculating a change in the temperature in the charge/discharge cycle from the previous charge/discharge cycle in each of the charge/discharge cycles; and diagnosing an internal short circuit in the battery cell based on the change in the charge efficiency and the change in the temperature.

The diagnosing of an internal short circuit in the battery cell may include: counting a violation if the change in the temperature calculated in a first charge/discharge cycle in which the change in the charge efficiency is greater than or equal to a first threshold value is greater than or equal to a second threshold value; and determining that the battery cell is internally short-circuited if the number of violations is greater than a reference number.

The diagnosing of an internal short circuit in the battery cell may include determining that the battery cell is internally short-circuited if a change in charge efficiency compared to a previous charge/discharge cycle is greater than or equal to a first threshold value and the change in temperature is greater than or equal to a second threshold value.

The measuring the charge efficiency of the battery cell may include: measuring a charge capacity of the battery cell in a charging period in each of the charge/discharge cycles; measuring a discharge capacity of the battery cell in a discharge period in each of the charge/discharge cycles; and calculating the charge efficiency using the charge capacity of the battery cell and the discharge capacity of the battery cell in each of the charge/discharge cycles.

According to another embodiment, an apparatus for diagnosing an internal short circuit in a battery may be provided. The apparatus for diagnosing an internal short circuit in a battery includes: a charging and discharging device configured to charge a battery cell in a charging period and discharge the battery cell in a discharging period of each of a plurality of charge/discharge cycles; a measurement device configured to measure a charge capacity of the battery cell in the charge period and a discharge capacity of the battery cell in the discharge period of each of the charge/discharge cycles, and measure a temperature of the battery cell in each of the charge/discharge cycles; and a controller configured to (i) generate a first curve representing a change in charge efficiency compared to a previous charge/discharge cycle and a second curve representing a change in temperature compared to the previous charge/discharge cycle for each of the charge/discharge cycles, and (ii) diagnose an internal short circuit of the battery cell based on the first curve and the second curve.

The controller may be configured to determine that the battery cell is internally short-circuited if the change in charge efficiency compared to the previous charge/discharge cycle is greater than or equal to a first threshold value and the change in temperature compared to the previous charge/discharge cycle is greater than or equal to a second threshold value.

The first threshold value may be set as a criterion for determining the amount of increase in charge efficiency, and the second threshold value may be set as a criterion for determining the amount of increase in temperature.

The controller may be configured to determine that the battery cell is internally short-circuited if the number of times during which the change in the charge/discharge efficiency compared to the previous charge/discharge cycle is greater than or equal to a first threshold value and the change in the temperature compared to the previous charge/discharge cycle is greater than or equal to a second threshold value is greater than or equal to a reference number.

The controller may be configured to discharge the battery cell when it is determined that the battery cell is internally short-circuited.

According to another embodiment, a method for diagnosing an internal short circuit in a battery cell, wherein the method includes: measuring a charge efficiency of a battery cell and a temperature of the battery cell in a first charge/discharge cycle; measuring the charge efficiency of the battery cell and the temperature of the battery cell in a second charge/discharge cycle after the first charge/discharge cycle; increasing a number of violations if a change in charge efficiency of the battery cell between the first charge/discharge cycle and the second charge/discharge cycle is greater than or equal to a first threshold value, and a change in temperature of the battery cell between the first charge/discharge cycle and the second charge/discharge cycle is greater than or equal to a second threshold value; and determining whether there is an internal short circuit in the battery cell based on the number of violations.

The determining may include determining that an internal short circuit has occurred in the battery cell if the number of violations reaches a reference number.

The method for diagnosing an internal short circuit in a battery may further include: measuring a charge efficiency of the battery cell and a temperature of the battery cell in a third charge/discharge cycle; measuring a charge efficiency of the battery cell and a temperature of the battery cell in a fourth charge/discharge cycle after the third charge/discharge cycle; and increasing the number of violations if a change in charge efficiency of the battery cell between the third charge/discharge cycle and the fourth charge/discharge cycle is greater than or equal to the first threshold value and a change in temperature of the battery cell between the third charge/discharge cycle and the fourth charge/discharge cycle is greater than or equal to the second threshold value.

At least some of the above and other features of the invention are set out in the claims.

### BRIEF DESCRIPTION OF THE DRAWINGS

FIG. 1 shows an apparatus for diagnosing internal short circuit in a battery according to an embodiment.
FIG. 2 shows the charge capacity and discharge capacity of a battery cell for each charge/discharge cycle.
FIG. 3 shows the temperature of a battery cell for each charge/discharge cycle of the battery cell.
FIG. 4 is a flowchart illustrating a method of diagnosing an internal short circuit in a battery cell according to an embodiment.
FIG. 5 is a flowchart illustrating a method of diagnosing an internal short circuit in a battery cell according to another embodiment.
FIG. 6 shows an apparatus for diagnosing internal short circuit in a battery according to another embodiment.

### DETAILED DESCRIPTION OF THE EMBODIMENTS

Example embodiments will now be described more fully hereinafter with reference to the accompanying drawings. However, the present disclosure may be embodied in different forms and should not be construed as limited to the embodiments set forth herein. Rather, these embodiments are provided so that this disclosure will be thorough and complete, and will fully convey example implementations to those skilled in the art. The drawings and description are to be regarded as illustrative in nature and not restrictive. Like reference numerals designate like elements throughout the specification. In the flowcharts described with reference to the drawings in this specification, the order of operations may be changed, several operations may be merged, some operations may be divided, and specific operations may not be performed.

Throughout the specification and claims, if a part is referred to "include" a certain element, it may mean that it may further include other elements rather than exclude other elements, unless specifically indicated otherwise.

In addition, expressions described in the singular may be interpreted in the singular or plural unless explicit expressions such as "one" or "single" are used.

In addition, terms including an ordinal number, such as first, second, etc., may be used to describe various elements, but the elements are not limited by the terms. Such terms are used only for the purpose of distinguishing one element from another element. For example, without departing from the scope of the present disclosure, a first element may be referred to as a second element, and similarly, a second element may be referred to as a first element.

Furthermore, if a component is referred to be "connected" with another component, it includes not only the case where two components are "directly connected" but also the case where two components are "indirectly or non-contactedly connected" with another component interposed therebetween, or the case where two components are "electrically connected." On the other hand, if an element is referred to as "directly connected" to another element, it should be understood that no other element exists in the middle.

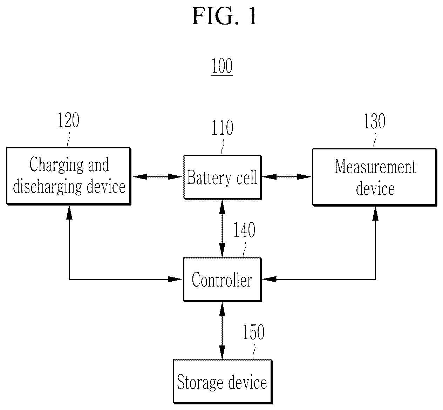

FIG. 1 shows an apparatus for diagnosing an internal short circuit in a battery according to an embodiment.

Referring to FIG. 1, the apparatus 100 for diagnosing an internal short circuit in a battery may include a battery cell 110, a charging and discharging device 120, a measurement device 130, a controller 140, and a storage device 150.

The battery cell 110 may be made by manufacturing an anode and a cathode using anode active materials and cathode active materials capable of absorbing and releasing lithium ions, respectively, installing a separator between the anode and the cathode, and then providing an electrolyte. The battery cell 110 may be a cell that has been completely made in a manufacturing process. The battery cell 110 may be inserted within the chamber.

The charging and discharging device 120 may charge or discharge the battery cell 110 based on the charge/discharge control signal of the controller 140.

The measurement device 130 may measure characteristic values of the battery cell 110 for each charge/discharge cycle based on a measurement control signal of the controller 140. The measurement device 130 may also transmit the characteristic values of the battery cell 110 to the controller 140. In addition, the measurement device 130 may measure the temperature of the battery cell 110 for each charge/discharge cycle. For example, the measurement device 130 may include a temperature sensor for measuring the temperature of the battery cell 110 for each charge/discharge cycle. One charge/discharge cycle may include a charge period, a rest period, a discharge period, and a rest period.

The controller 140 may collect the characteristic values of the battery cell 110 and the temperature of the battery cell 110 measured for each charge/discharge cycle. The controller 140 may diagnose an internal short circuit of the battery cell 110 due to the precipitation of lithium salts of the battery cell 110 based on the characteristic values of the battery cell 110 measured for each charge/discharge cycle and the temperature of the battery cell 110.

According to an embodiment, the characteristic values of the battery cell 110 may include the charge capacity of the battery cell 110 and the discharge capacity of the battery cell 110.

The charging and discharging device 120 may charge the battery cell 110 in the charging period. And the charging and discharging device 120 may discharge the battery cell 110 in the discharging period. The rest period may be a period for stabilizing the battery cell 110.

According to an embodiment, the measurement device 130 may measure the charge capacity of the battery cell 110 if the charge period of the charge/discharge cycle ends based on the measurement control signal of the controller 140, and measure the discharge capacity of the battery cell 110 if the discharge period of the charge/discharge cycle ends. In addition, the measurement device 130 may measure the temperature of the battery cell 110 if the charging period of the charge/discharge cycle ends through the temperature sensor, and the measurement device 130 may measure the temperature of the battery cell 110 if the discharging period of the charge/discharge cycle ends.

The measurement device 130 may transmit the charge capacity of the battery cell 110 measured at each charge/discharge cycle and the temperature of the battery cell 110 measured at that time. The measurement device 130 may also transmit the discharge capacity of the battery cell 110 at each charge/discharge cycle and the temperature of the battery cell 110 measured at that time to the controller 140. For example, if a total of 300 charge/discharge cycles are performed, the controller 140 may obtain the charge capacity of the battery cell 110 for each of the 300 cycles, the temperature of the battery cell 110 at the end of the charge for each of the 300 cycles, and the discharge capacity of the battery cell 110 for each of the 300 cycles, and the temperature of the battery cell 110 at the end of the discharge for each of the 300 cycles.

The controller 140 may store the charge capacity of the battery cell 110 and the discharge capacity of the battery cell 110 for each charge/discharge cycle, the temperature of the battery cell 110 at the end of charging for each charge/discharge cycle, and the temperature of the battery cell 110 at the end of discharging for each charge/discharge cycle in the storage device 150.

The controller 140 may pre-diagnose an internal short circuit of the battery cell 110 due to the precipitation of lithium salts based on the charge capacity of the battery cell 110 and the discharge capacity of the battery cell 110, the temperature of the battery cell 110 at the end of charging, and the temperature of the battery cell 110 at the end of discharging as the charge and discharge cycles progress.

In case of a normal battery cell 110, the charge discharge efficiency (including charge efficiency and/or coulombic efficiency) is expressed as a percentage of the discharge capacity to the charge capacity. The charge efficiency gradually increases as the cycle progresses, and the charge efficiency higher than a predetermined reference (e.g., 95%) may be maintained after the initial charge/discharge cycle (e.g., 5 charge/discharge cycles). But, in the case of a battery cell with an abnormality (e.g., internal short circuit), the charge efficiency may drop below 90%, an exothermic reaction due to the precipitation of irreversible lithium salts may be occurred, and the cell temperature may be increased. Accordingly, the controller 140 may calculate the charge efficiency of the battery cell 110 for each charge/discharge cycle, and diagnose an internal short circuit based on the charge efficiency of the battery cell 110 for each charge/discharge cycle and the temperature of the battery cell 110 for each charge/discharge cycle.

In some embodiments, after the charge efficiency is maintained at 95% or more for a predetermined period of time, the controller may calculate the change in charge efficiency of the battery cell 110 between the current charge/discharge cycle and the previous charge/discharge cycle and the change in temperature of the battery cell 110 between the current charge/discharge cycle and the previous charge/discharge cycle. Thus, the controller can diagnose an internal short circuit of the battery cell 110 based on the change in charge efficiency and the change in temperature calculated in each charge/discharge cycle.

In the present disclosure, the change in temperature of the battery cell 110 may represent the difference between the temperature measured at the end of charging in the current charge/discharge cycle and the temperature measured at the end of charging in the previous charge/discharge cycle, or may represent the difference between the temperature measured at the end of discharging in the current charge/discharge cycle and the temperature measured at the end of discharging in the previous charge/discharge cycle.

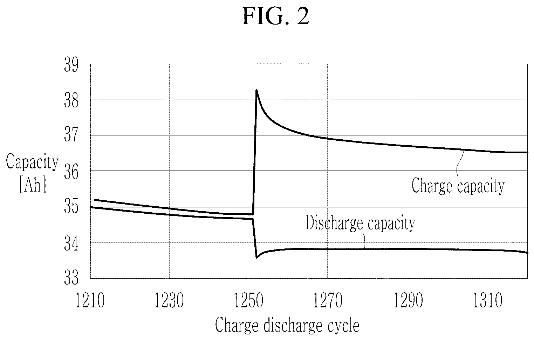

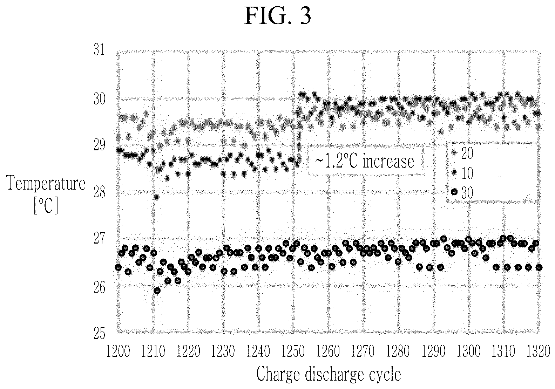

FIG. 2 is a diagram showing the charge capacity and discharge capacity of a battery cell for charge/discharge cycles, and FIG. 3 is a diagram showing the temperature of a battery cell for charge/discharge cycles of a battery cell.

In case of the normal battery cell 10, charge efficiency higher than a predetermined reference (e.g., 95%) may be maintained as the charge/discharge cycles progress. But, as the charge/discharge cycle progresses, if the cathode and the anode of the battery cell 10 are short-circuited due to the precipitation of irreversible lithium salts, the charge capacity may rapidly increase and the discharge capacity may rapidly decrease as compared to the charge capacity and discharge capacity of the previous charge/discharge cycles, as shown in FIG. 2 (part of 1250 charge/discharge cycle). Accordingly, the change in charge efficiency may decrease rapidly.

In addition, as shown in FIG. 3, in the case of normal cells 20, and 30, even when charge/discharge cycles are progressing, the change in temperature between the current charge/discharge cycle and the previous charge/discharge cycle does not exceed a set threshold value (e.g., 1 °C). But, when an internal short-circuited cell 10 occurs due to the precipitation of lithium salts, the cell temperature of the internally shorted cell 10 increases rapidly. That is, when the cell 10 is short-circuited due to the precipitation of lithium salts, a point where the change in temperature of the battery cell 110 between the current charge/discharge cycle and the previous charge/discharge cycle exceeds a threshold value, may have occurred, and then an increased cell temperature is maintained.

The controller 140 may set a threshold value for the change in charge efficiency compared to the previous charge/discharge cycle and a threshold value for the change in temperature compared to the previous charge/discharge cycle based on the characteristics of the battery cell 10 due to the precipitation of lithium salts. The controller 140 may also compare the change in charge efficiency and the change in temperature compared to the previous charge/discharge cycle with the threshold values and diagnose an internal short circuit of the battery cell 10.

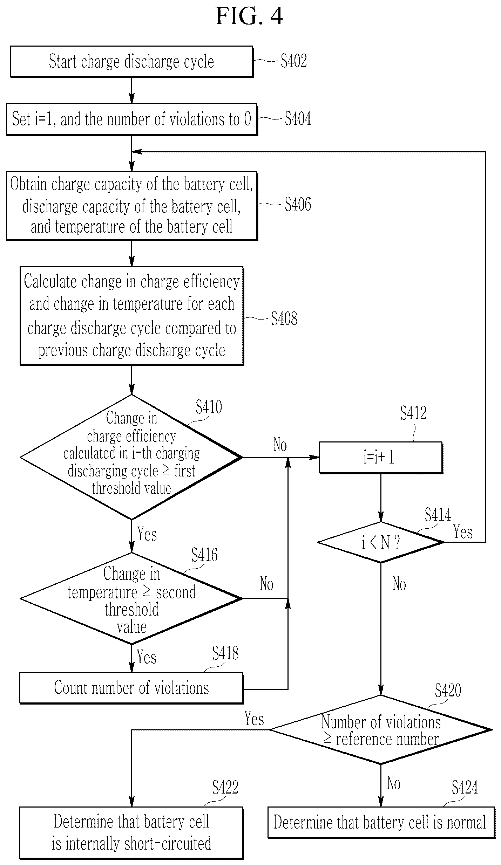

FIG. 4 is a flowchart illustrating a method of diagnosing an internal short circuit in a battery cell according to an embodiment.

Referring to FIG. 4, when a charge/discharge cycle starts (S402), the controller 140 may set i=1, and the number of violations to 0 (S404).

The controller 140 may obtain the charge capacity of the battery cell 110 and the discharge capacity of the battery cell 110 for each charge/discharge cycle, the temperature of the battery cell 110 at the end of charging for each charge/discharge cycle, and the temperature of the battery cell 110 at the end of discharging for each charge/discharge cycle (S406).

The controller 140 may calculate the change in charge efficiency and the change in temperature for each charge/discharge cycle as compared to the previous charge/discharge cycle (S408). And the controller 140 may calculate the change in charge efficiency and the change in temperature for each charge/discharge cycle as compared to the previous charge/discharge cycle as the charge/discharge cycles progress.

The controller 140 may perform the following process from while the charge efficiency is maintained above a certain value for a certain period of time. Alternatively, the following process may be performed starting from i=1. The certain value may be set, for example, to 95%. The controller 140 may determine that the battery cell 110 is normal if the change in charge efficiency calculated in the i-th charging/discharging cycle is less than a first threshold value. Here, i may be a charge/discharge cycle at a time at which the charge efficiency is maintained above the certain value.

The controller 140 may compare the change in charge efficiency of the i-th charge/discharge cycle with the first threshold value (S410). If the change in charge efficiency of the i-th charge/discharge cycle is less than the first threshold value, the controller 140 may set i=i+1 (S412), and check whether i is less than N (S414). Here, N may represent a total number of charge/discharge cycles. And the controller 140 may return to step S406 if i is less than N.

Meanwhile, if the change in charge efficiency of the i-th charge/discharge cycle is greater than or equal to the first threshold value S410, the controller 140 may check the change in temperature in the i-th charge /discharge cycle. And the controller 140 may perform step S412 if the change in temperature in the i-th charge/discharge cycle is less than a second threshold value (S416).

If the change in temperature in the i-th charge/discharge cycle is greater than or equal to the second threshold value, the controller 140 may increase the number of violations by 1 (S418) and perform step S412. The controller 140 may then check whether the number of violations is greater than or equal to a reference number if i becomes N (S420). At this time, the reference number may be set, for example, to 1 or 2. The controller 140 may thereby determine that the battery cell is internally short-circuited (S422) if the number of violations is greater than or equal to a standard number (S420). But the controller 140 may determine that the battery cell is normal (S424) if the number of violations is less than the reference number (S420).

In FIG. 4, the step S420 is illustrated as being performed if i becomes N (S414), but, alternatively, the step S420 may be performed after step S418. That is, if the change in temperature in the i-th charge/discharge cycle is greater than or equal to the second threshold value, the controller 140 may increase the number of violations by 1 (S418) and check whether the number of violations is greater than or equal to the reference number. At this time, the controller 140 may perform step S412 if the number of violations is less than the reference number.

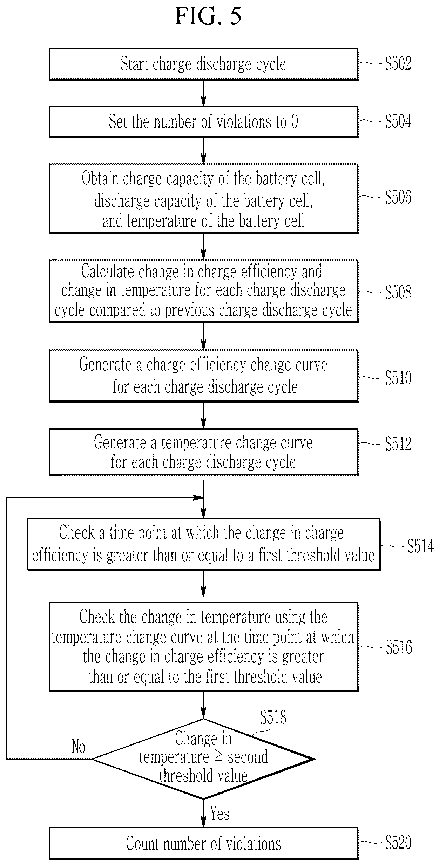

FIG. 5 is a flowchart illustrating a method of diagnosing an internal short circuit in a battery cell according to another embodiment.

Referring to Fig. 5, when a charge/discharge cycle starts (S502), the controller 140 may set the number of violations to 0 (S504).

The controller 140 may obtain the charge capacity of the battery cell 110 and the discharge capacity of the battery cell 110 for each charge/discharge cycle, the temperature of the battery cell 110 at the end of charging for each charge/discharge cycle, and the temperature of the battery cell 110 at the end of discharging for each charge/discharge cycle (S506).

The controller 140 may calculate the change in charge efficiency and the change in temperature for each charge/discharge cycle compared to the previous charge/discharge cycle (S508).

The controller 140 may generate a charge efficiency change curve for each charge/discharge cycle that represents the difference in charge efficiency compared to the previous charge/discharge cycle (S510).

The controller 140 may generate a temperature change curve for each charge/discharge cycle that represents the difference in temperature of the battery cell 110 compared to the previous charge/discharge cycle (S512).

The controller 140 may check a time at which the change in charge efficiency is greater than or equal to a first threshold value in the charge efficiency change curve for each charge/discharge cycle (S514).

The controller 140 may check the change in temperature using the temperature change curve at the time at which the change in charge efficiency is greater than or equal to the first threshold value (S516).

The controller 140 may count the number of violations (S520) if the change in temperature is greater than or equal to the second threshold value at the time at which the change in charge efficiency is greater than or equal to the first threshold value (S518). As described in steps S420 to S424 of FIG. 4, the controller 140 may determine that the battery cell 110 is internally short-circuited if the number of violations counted after a charge/discharge cycle is greater than or equal to a reference number. And the controller 140 may determine that the battery cell 110 is normal if the number of violations counted after a charge/discharge cycle is less than a reference number.

In this way, according to an embodiment, an internal short circuit due to the precipitation of lithium salts of a battery cell 110 may be pre-diagnosed by utilizing the charge discharge efficiency, and temperature characteristics of the battery cell 110. The controller 140 discharges the battery cell 110 when it is determined that the battery cell 110 is internally short-circuited

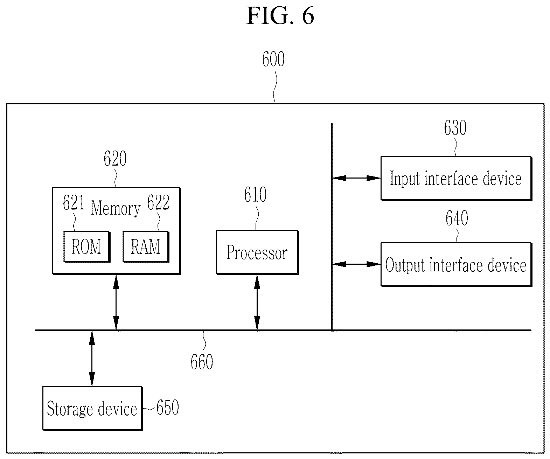

FIG. 6 is a drawing showing an apparatus for diagnosing internal short circuit in a battery according to another embodiment.

Referring to FIG. 6, an apparatus 600 for diagnosing internal short circuit in a battery may be a computing device with which the method of diagnosing internal short circuit in a battery described above is implemented.

The apparatus 600 for diagnosing internal short circuit in a battery may include at least one of a processor 610, a memory 620, an input interface device 630, an output interface device 640, and a storage device 650. Each component may be connected by a bus 660 and may communicate with each other. In addition, each component may be connected through an individual interface or individual bus centered on the processor 610, rather than the common bus 660.

The processor 610 may be implemented as various types such as an application processor (AP), a central processing unit (CPU), a graphics processing unit (GPU), etc., and may be any semiconductor device that executes a command stored in the memory 620 or storage device 650. The processor 610 may perform the internal short circuit diagnosis function of the battery described with reference to FIGS. 1 to 5 by executing program commands stored in at least one of the memory 620 and the storage device 650.

The memory 620 and storage device 650 may include various forms of volatile or non-volatile storage media. For example, the memory 620 may include a read-only memory (ROM) 621 and a random access memory (RAM) 622. In an embodiment, the memory 620 may be located inside or outside the processor 610, and the memory 620 may be connected to the processor 610 through various known means.

The input interface device 630 may be configured to provide data to the processor 610. In some embodiments, the input interface device 630 may provide the charge capacity, discharge capacity, and temperature of the battery cell 110 for each charge/discharge cycle to the processor 610.

The output interface device 640 may be configured to output data from the processor 610. In some embodiments, the output interface device 640 may output an internal short circuit diagnosis result of the battery cell 110.

According to at least one embodiment, an internal short circuit caused by the precipitation of lithium salts in a lithium secondary battery may be diagnosed in advance of a problem occurring in the battery, such as thermal runaway or a fire.

Although the embodiments of the present disclosure have been described in detail above, the scope of the present disclosure is not limited thereto, and various modifications and improvements of those skilled in the art using the basic concepts of the present disclosure.

### <Description of some symbols>

100: Apparatus for diagnosing an internal short circuit in a battery
110: Battery cell
120: Charging and discharging device
130: Measurement device
140: Controller
150: Storage device

## Claims

1. A method of diagnosing an internal short circuit in a battery cell, the method comprising:
measuring charge efficiency of a battery cell in each of a plurality of charge/discharge cycles;
measuring a temperature of the battery cell in each of the charge/discharge cycles;
calculating a change in the charge efficiency in a charge/discharge cycle from a previous charge/discharge cycle in each of the plurality of charge/discharge cycles;
calculating a change in the temperature in the charge/discharge cycle from the previous charge/discharge cycle in each of the charge/discharge cycles; and
diagnosing an internal short circuit in the battery cell based on the change in the charge efficiency and the change in the temperature.

2. The method of claim 1, wherein the diagnosing of an internal short circuit in the battery cell includes:
counting a violation if the change in the temperature calculated in a first charge/discharge cycle in which the change in the charge efficiency is greater than or equal to a first threshold value is greater than or equal to a second threshold value; and
determining that the battery cell is internally short-circuited if the number of violations is greater than a reference number.

3. The method of claim 1 or claim 2, wherein the diagnosing of an internal short circuit in the battery cell includes determining that the battery cell is internally short-circuited if a change in charge efficiency compared to a previous charge/discharge cycle is greater than or equal to a first threshold value and the change in temperature is greater than or equal to a second threshold value.

4. The method of any preceding claim, wherein the measuring of the charge efficiency of the battery cell includes:
measuring a charge capacity of the battery cell in a charging period in each of the charge/discharge cycles;
measuring a discharge capacity of the battery cell in a discharge period in each of the plurality of charge/discharge cycles; and
calculating the charge efficiency using the charge capacity of the battery cell and the discharge capacity of the battery cell in each of the charge/discharge cycles.

5. An apparatus for diagnosing an internal short circuit in a battery cell, the apparatus comprising:
a charging and discharging device configured to charge a battery cell in a charging period and discharge the battery cell in a discharging period of each of a plurality of charge/discharge cycles;
a measurement device configured to measure a charge capacity of the battery cell in the charge period and a discharge capacity of the battery cell in the discharge period of each of the charge/discharge cycles, and measure a temperature of the battery cell in each of the charge/discharge cycles; and
a controller configured to (i) generate a first curve representing a change in charge efficiency compared to a previous charge/discharge cycle and a second curve representing a change in temperature compared to the previous charge/discharge cycle for each of the charge/discharge cycles and (ii) diagnose an internal short circuit of the battery cell based on the first curve and the second curve.

6. The apparatus of claim 5, wherein the controller is further configured to determine that the battery cell is internally short-circuited if the change in charge efficiency compared to the previous charge/discharge cycle is greater than or equal to a first threshold value and the change in temperature compared to the previous charge/discharge cycle is greater than or equal to a second threshold value.

7. The apparatus of claim 6, wherein the first threshold value is set as a criterion for determining the amount of increase in charge efficiency, and the second threshold value is set as a criterion for determining the amount of increase in temperature.

8. The apparatus of any of claims 5-7, wherein the controller is further configured to determine that the battery cell is internally short-circuited if the number of times during which the change in the charge/discharge efficiency compared to the previous charge/discharge cycle is greater than or equal to a first threshold value and the change in the temperature compared to the previous charge/discharge cycle is greater than or equal to a second threshold value is greater than or equal to a reference number.

9. The apparatus of any of claims 5-8, wherein the controller is further configured to discharge the battery cell when it is determined that the battery cell is internally short-circuited.

10. A method for diagnosing an internal short circuit in a battery cell, the method comprising:
measuring a charge efficiency of a battery cell and a temperature of the battery cell in a first charge/discharge cycle;
measuring the charge efficiency of the battery cell and the temperature of the battery cell in a second charge/discharge cycle after the first charge/discharge cycle;
increasing a number of violations if a change in charge efficiency of the battery cell between the first charge/discharge cycle and the second charge/discharge cycle is greater than or equal to a first threshold value and a change in temperature of the battery cell between the first charge/discharge cycle and the second charge/discharge cycle is greater than or equal to a second threshold value; and
determining whether there is an internal short circuit in the battery cell based on the number of violations.

11. The method of claim 10, wherein the determining includes determining that an internal short circuit has occurred in the battery cell if the number of violations reaches a reference number.

12. The method of claim 10 or claim 11, further comprising:
measuring a charge efficiency of the battery cell and a temperature of the battery cell in a third charge/discharge cycle;
measuring a charge efficiency of the battery cell and a temperature of the battery cell in a fourth charge/discharge cycle after the third charge/discharge cycle; and
increasing the number of violations if a change in charge efficiency of the battery cell between the third charge/discharge cycle and the fourth charge/discharge cycle is greater than or equal to the first threshold value and a change in temperature of the battery cell between the third charge/discharge cycle and the fourth charge/discharge cycle is greater than or equal to the second threshold value.
